# EUROPEAN PATENT APPLICATION

(11) **EP 2 538 453 A1**
(43) Date of publication of application: **26.12.2012**
(21) Application number: 11822021.9
(22) Date of filing: 27.04.2011
(51) Int. Cl.: H01L 31/042

(54) **SOLAR POWER GENERATING DEVICE, AND METHOD FOR MANUFACTURING SAME**

(30) Priority: 01.09.2010 KR 20100085584
(71) Applicant: LG Innotek Co., Ltd., Seoul 100-714 (KR)
(72) Inventor: LEE, JinWoo, Seoul 100-714 (KR)
(74) Representative: Novagraaf Technologies
(86) International application number: PCT/KR2011/003119
(87) International publication number: WO 2012/030046

(57) **Abstract**

Disclosed are a solar cell apparatus and a method of fabricating the same. The solar cell apparatus includes a substrate, a back electrode layer on the substrate, a light absorbing layer on the back electrode layer, and a window layer on the light absorbing layer. A third through hole is formed through an entire portion of the window layer and a portion of the light absorbing layer.

## Description

### Technical Field

The embodiment relates to a solar cell apparatus and a method of fabricating the same.

### Background Art

Recently, as energy consumption is increased, a solar cell apparatus has been developed to convert solar energy into electrical energy.

In particular, a CIGS-based solar cell apparatus, which is a PN hetero junction apparatus having a substrate structure including a glass substrate, a metallic back electrode layer, a P type CIGS-based light absorbing layer, a high resistance buffer layer, and an N type window layer, has been extensively used.

### Disclosure

### Technical Problem

The embodiment provides a solar cell apparatus capable of preventing short while representing improved photoelectric conversion efficiency and a method of fabricating the same.

### Technical Solution

According to the embodiment, there is provided a solar cell apparatus including a substrate, a back electrode layer on the substrate, a light absorbing layer on the back electrode layer, and a window layer on the light absorbing layer. A third through hole is formed through an entire portion of the window layer and a portion of the light absorbing layer.

According to the embodiment, there is provided a solar cell apparatus including a substrate, a back electrode layer on the substrate, a light absorbing layer on the back electrode layer, a window layer having a third through hole on the light absorbing layer, and a dummy protective part interposed between the third through hole and the back electrode layer.

According to the embodiment, there is provided a method of fabricating a solar cell apparatus. The method includes forming a back electrode layer on a substrate, forming a light absorbing layer on the back electrode layer, forming a window layer on the light absorbing layer, and forming a third through hole through an entire portion of the window layer and a portion of the light absorbing layer.

### Advantageous Effects

According to the solar cell apparatus of the embodiment, the third through hole is formed through a portion of the light absorbing layer. Therefore, the third through hole does not expose the back electrode layer.

Accordingly, since the back electrode layer is not exposed to the outside, the back electrode layer is not damaged by external foreign matters. In other words, even if the third through hole is formed, the top surface of the back electrode layer can be protected by the dummy protective part. Therefore, according to the solar cell apparatus of the embodiment, efficiency can be prevented from being lowered due to the damage of the back electrode layer.

In addition, the third through hole can be formed through an etching process. In particular, the third through hole can be formed through a wet etching process. Therefore, the foreign matters created when the third through hole is formed can be easily cleaned by the etching solution. Accordingly, the foreign matters do not remain in the third through hole, and the short caused by the foreign matters can be prevented.

Therefore, according to the solar cell apparatus of the embodiment, the short can be prevented, and the failure rate can be reduced.

### Description of Drawings

FIG. 1 is a plan view showing a solar cell apparatus according to the embodiment;

FIG. 2 is a sectional view taken along line A-A' of FIG. 1; and

FIGS. 3 to 7 are sectional views showing the fabricating process of the solar cell apparatus according to the embodiment.

### Best Mode

In the description of the embodiments, it will be understood that when a substrate, a layer, a film or an electrode is referred to as being "on" or "under" another substrate, another layer, another film or another electrode, it can be "directly" or "indirectly" on the other substrate, the other layer, the other film, or the other electrode, or one or more intervening layers may also be present. Such a position of the layer has been described with reference to the drawings. The size of the elements shown in the drawings may be exaggerated for the purpose of explanation and may not utterly reflect the actual size.

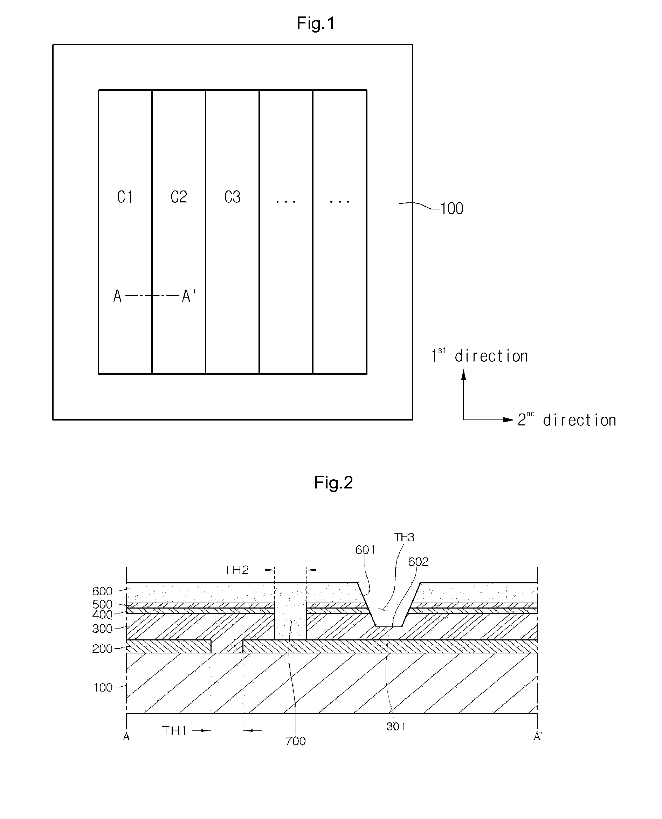

FIG. 1 is a plan view showing a solar cell apparatus according to the embodiment, and FIG. 2 is a sectional view taken along line A-A' of FIG. 1.

Referring to FIGS. 1 and 2, the solar cell apparatus includes a support substrate 100, a back electrode layer 200, a light absorbing layer 300, a buffer layer 400, a high resistance buffer layer 500, a window layer 600, and a plurality of connection parts 700.

The support substrate 100 has a plate shape and supports the back electrode layer 200, the light absorbing layer 300, the buffer layer 400, the high resistance buffer layer 500, the window layer 600, and the connection parts 700.

The support substrate 100 may include an insulator. The support substrate 100 may include a glass substrate, a plastic substrate, or a metallic substrate. In more detail, the support substrate 100 may include a soda lime glass substrate. The support substrate 100 may be transparent or may be rigid or flexible.

The back electrode layer 200 is provided on the substrate 100. The back electrode layer 200 may be a metallic layer. The back electrode layer 200 may include a metal, such as molybdenum (Mo).

In addition, the back electrode layer 200 may include at least two layers. In this case, the layers may be formed by using the homogeneous metal or heterogeneous metals.

The back electrode layer 200 is formed therein with first through holes TH1. The first through holes TH1 are open regions to expose the top surface of the support substrate 100. When viewed in a plan view, the first through holes TH1 may extend in one direction.

Each first through hole TH1 has a width in the range of about 80 µm to about 200µm.

The back electrode layer 200 is divided into a plurality of back electrodes by the first through holes TH1. In other words, the back electrodes are defined by the first through holes TH1.

The back electrodes are spaced apart from each other by the first through holes TH1. The back electrodes are arranged in the form of a stripe.

In addition, the back electrodes may be arranged in the form of a matrix. In this case, the first through holes TH1 may have the form of a lattice when viewed in a plan view.

The light absorbing layer 300 is provided on the back electrode layer 200. In addition, a material constituting the light absorbing layer 300 is filled in the first through holes TH1.

The light absorbing layer 300 includes a group I-III-VI compound. For example, the light absorbing layer 300 may have a Cu(In,Ga)Se₂ (CIGS) crystal structure, a Cu(In)Se₂ crystal structure, or a Cu(Ga)Se₂ crystal structure.

The light absorbing layer 300 may have an energy bandgap in the range of about 1eV to about 1.8eV.

The buffer layer 400 is provided on the light absorbing layer 300. The buffer layer 400 includes CdS and has an energy bandgap in the range of about 2.2eV to about 2.4eV.

The high resistance buffer layer 500 is provided on the buffer layer 400. The high-resistance buffer layer 400 may include iZnO, which is zinc oxide not doped with impurities. The high resistance buffer layer 500 has an energy bandgap in the range of about 3.1eV to about 3.3eV.

The light absorbing layer 300, the buffer layer 400, and the high resistance buffer layer 500 are formed therein with second through holes TH2. The second through holes TH2 are formed through the light absorbing layer 300. In addition, the second through holes TH2 are open regions to expose the top surface of the back electrode layer 200.

The second through holes TH2 are adjacent to the first through holes TH1. In other words, when viewed in a plan view, portions of the second through holes TH2 are formed beside the first through holes TH1. The second through holes TH2extend in a first direction.

Each second through hole TH2 may have a width in the range of about 80µm to about 200 µm.

A plurality of light absorbing parts are defined in the light absorbing layer 300 by the second through holes TH2. In other words, the light absorbing layer 300 is divided into the light absorbing parts by the second through holes TH2.

A plurality of buffers are defined in the buffer layer 400 by the second through holes TH2. In other words, the buffer layer 400 is divided into the buffers through the second through holes TH2.

A plurality of buffers are defined in the high resistance buffer layer 500 by the second through holes TH2. In other words, the high resistance buffer layer 500 is divided into the high resistance buffers by the second through holes TH2.

The window layer 600 is provided on the high resistance buffer layer 500. The window layer 600 is transparent, and includes a conductive layer. In addition, the window layer 600 has resistance greater than that of the back electrode layer 200.

The window layer 600 includes an oxide. For example, the window layer 600 may include an A1 doped zinc oxide (AZO), or a Ga doped zinc oxide (GZO).

The light absorbing layer 300, the buffer layer 400, the high resistance buffer layer 500, and the window layer 600 are formed therein with third through holes TH3. The third through holes TH3 are formed through a portion of the light absorbing layer 300, an entire portion of the buffer layer 400, the entire portion of the high resistance buffer layer 500, and an entire portion of the window layer 600.

Since the third through holes TH3 are formed through a portion of the light absorbing layer 300, a plurality of protective parts 301 are formed in the light absorbing layer 300. In addition, a bottom surface 602 of each third through holes TH3 is interposed between the top surface and the bottom surface of the light absorbing layer 300.

The dummy protective parts 301 may be integrally formed with the light absorbing layer 300. Each dummy protective part 301 may correspond to each third through hole TH3. Therefore, the top surface of the dummy protective part 301 may be aligned in line with the bottom surface of the third through hole TH3. The top surface of the dummy protective part 301 is placed between the top surface and the bottom surface of the light absorbing layer 300.

The dummy protective parts 301 are integrally formed with the light absorbing layer 300. In more detail, the dummy protective parts 301 may be a portion of the light absorbing layer 300. The dummy protective parts 301 are interposed between the third through holes TH3 and the back electrode layer 200. In addition, the dummy protective parts 301 cover the top surface of the back electrode layer 200. Accordingly, the dummy protective parts 301 do not expose the top surface of the back electrode layer 200.

The third through holes TH3 are adjacent to the second through holes TH2. In more detail, the third through holes TH3 are provided beside the second through holes TH2. In other words, when viewed in a plan view, the third through holes TH3 are provided in parallel to the second through holes TH2. The third through holes TH3 may extend in the first direction.

An inner lateral side 601 of the third through holes TH3 may be inclined with respect to the top surface of the window layer 600. In this case, the inner lateral side 601 of the third through holes TH3 may be inclined at an angle of about 3° to 10° with respect to a direction perpendicular to the top surface of the window layer 600.

The third through holes TH3 are formed through the window layer 600. In more detail, the third through holes TH3 are formed through the buffer layer 400 and the high resistance buffer layer 500. In addition, the third through holes TH3 are formed through the portion of the light absorbing layer 300.

Therefore, a bottom surface 602 of each third through hole TH3 is provided inside the light absorbing layer 300. In other words, the bottom surface 602 of the third through hole TH3 is interposed between the top surface and the bottom surface of the light absorbing layer 300.

Therefore, the top surface of the back electrode layer 200 is prevented from being exposed by the third through holes TH3. In other words, the back electrode layer 200 can be protected by the light absorbing layer 300. Since the back electrode layer 200 is not exposed to the outside, the back electrode layer 200 can be prevented from being damaged due to external and chemical shocks.

The window layer 600 is divided into a plurality of windows by the third through holes TH3. In other words, the windows are defined by the third through holes TH3.

The windows have a shape corresponding to the shape of the back electrodes. In other words, the windows are arranged in the form of a stripe. In addition, the windows may be arranged in the form of a matrix.

A plurality of cells C1, C2, ..., and CN are defined by the third through holes TH3. In detail, the cells C1, C2, ..., and CN are defined by the second through hole TH2 and the third through hole TH3. In other words, the solar cell apparatus according to the embodiment is divided into the cells C1, C2,..., and CN by the second and third through holes TH2 and TH3. In addition, the cells C1, C2,..., and CN are connected to each other in a second direction crossing the first direction. In other words, current may flow in the second direction through the cells C1, C2,..., and CN.

In this case, since the third through holes TH3 are formed through the portion of the light absorbing layer 300, the window layer 600 can be completely divided into the windows. Therefore, in the solar cell apparatus according to the embodiment, the short occurring between the windows can be prevented.

The connection parts 700 are provided at the inside of the second through holes TH2. Each connection part 700 extends downward from the window layer 600 and is connected to the back electrode layer 200. For example, each connection part 700 is extended from the window of the first cell C 1 so that the connection part 700 is connected to the back electrode of the second cell C2.

In addition, the connection parts 700 connect adjacent cells to each other. In more detail, the connection parts 700 connect windows and back electrodes, which constitute adjacent cells C1, C2, ..., and CN, to each other.

Each connection part 700 is integrally formed with the window layer 600. In other words, a material constituting the connection part 700 is identical to a material constituting the window layer 600.

According to the solar cell apparatus of the embodiment, the third through holes TH3 are formed through the portion of the light absorbing layer 300. Therefore, the third through holes TH3 do not expose the back electrode layer 200.

Therefore, since the back electrode layer 200 is not exposed to the outside, the back electrode layer 200 is not damaged by external foreign matters. Therefore, according to the solar cell apparatus of the embodiment, efficiency can be prevented from being lowered due to the degradation of the back electrode layer 200.

Therefore, the solar cell apparatus according to the embodiment can represent the photoelectric conversion efficiency.

In addition, since the third through holes TH3 are formed through the portion of the light absorbing layer 300, the short between the windows can be prevented.

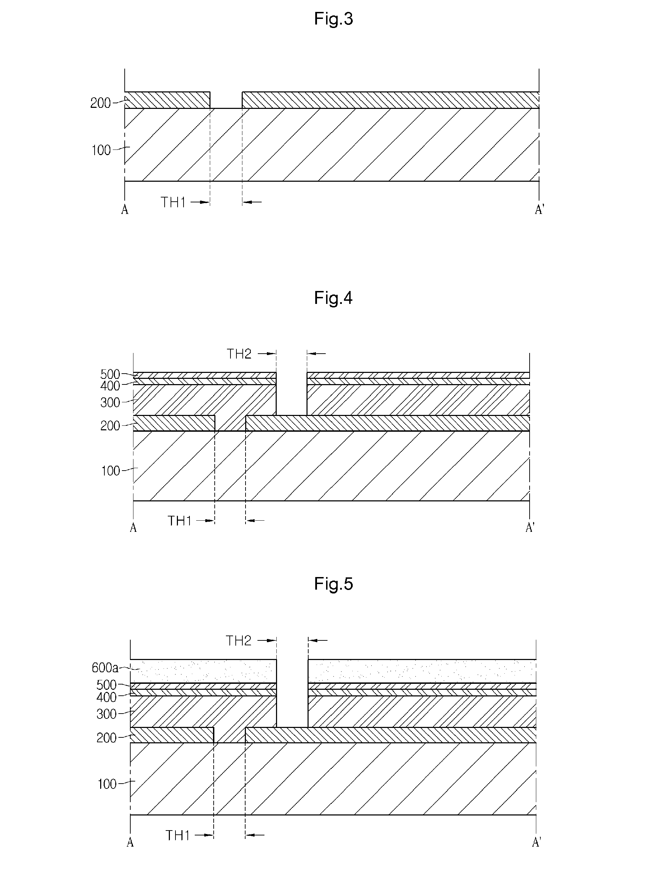

FIGS. 3 to 7 are sectional views showing the fabricating method of the solar cell apparatus according to the embodiment. The present fabricating method will be described by making reference to the above description of the solar cell apparatus. In other words, the above description of the solar cell apparatus may be incorporated in the description of the present fabricating method.

Referring to FIG. 3, the back electrode layer 200 is formed on the support substrate 100. The first through holes TH1 are formed by patterning the back electrode layer 200. Therefore, a plurality of back electrodes are formed on the support substrate 100. The back electrode layer 200 is patterned by a laser.

For example, a material constituting the back electrode layer 200 may include Mo. The back electrode layer 200 may include at least two layers formed through processes different from each other.

The first through holes TH1 may expose the top surface of the support substrate 100, and may have a width in the range of about 80µm to about 200 µm.

In addition, an additional layer such as an anti-diffusion layer may be interposed between the support substrate 100 and the back electrode layer 200. In this case, the first through holes TH1 expose the top surface of the additional layer.

Referring to FIG. 4, the light absorbing layer 300, the buffer layer 400, and the high resistance buffer layer 500 are formed on the back electrode layer 200.

The light absorbing layer 300 may be formed through a sputtering process or an evaporation process.

For example, the light absorbing layer 300 may be formed through various schemes such as a scheme of forming a Cu(In,Ga)Se₂ (CIGS) based light absorbing layer 300 by simultaneously or separately evaporating Cu, In, Ga, and Se and a scheme of performing a selenization process after a metallic precursor layer has been formed.

Regarding the details of the selenization process after the formation of the metallic precursor layer, the metallic precursor layer is formed on the back electrode layer 200 through a sputtering process employing a Cu target, an In target, a Ga target or an alloy target.

Thereafter, the metallic precursor layer is subject to the selenization process so that the Cu (In, Ga) Se₂ (CIGS) based light absorbing layer 300 is formed.

In addition, the sputtering process employing the Cu target, the In target, and the Ga target and the selenization process may be simultaneously performed.

Further, a CIS or a CIG based light absorbing layer 300 may be formed through the sputtering process employing only Cu and In targets or only Cu and Ga targets and the selenization process.

Thereafter, the buffer layer 400 is formed by depositing CdS through a sputtering process or a chemical bath deposition (CBD) scheme.

Next, the high resistance buffer layer 500 is formed by depositing a zinc oxide on the buffer layer 400 through the sputtering process.

The buffer layer 400 and the high resistance buffer layer 500 are deposited at a lower thickness. For example, the thickness of the buffer layer 400 and the high resistance buffer layer 500 is in the range of about 1nm to about 80nm.

The second through holes TH2 are formed by removing portions of the light absorbing layer 300, the buffer layer 400, and the high resistance buffer layer 500.

The second through holes TH2 may be formed by a mechanical device such as a tip or a laser device.

For example, the light absorbing layer 300 and the buffer layer 400 may be patterned by the tip having a width in the range of about 40µm to about 180 µm.

In this case, each second through hole TH2 has a width in the range of about 100µm to about 200µm. In addition, the second through holes TH2 expose a portion of the top surface of the back electrode layer 200.

Referring to FIG. 5, a transparent conductive layer 600a is formed on the light absorbing layer 300 and inside the second through holes TH2. In other words, the transparent conductive layer 600a is formed by depositing a transparent conductive material on the high resistance buffer layer 500 and inside the second through holes TH2.

For example, the transparent conductive layer 600a may be formed by deposing an A1 doped zinc oxide on the high resistance buffer layer 500 and inside the second through holes H2 through the sputtering process.

In this case, the transparent conductive material is filled in the second through holes TH2, so that the transparent conductive layer 600a directly makes contact with the conductive layer 200.

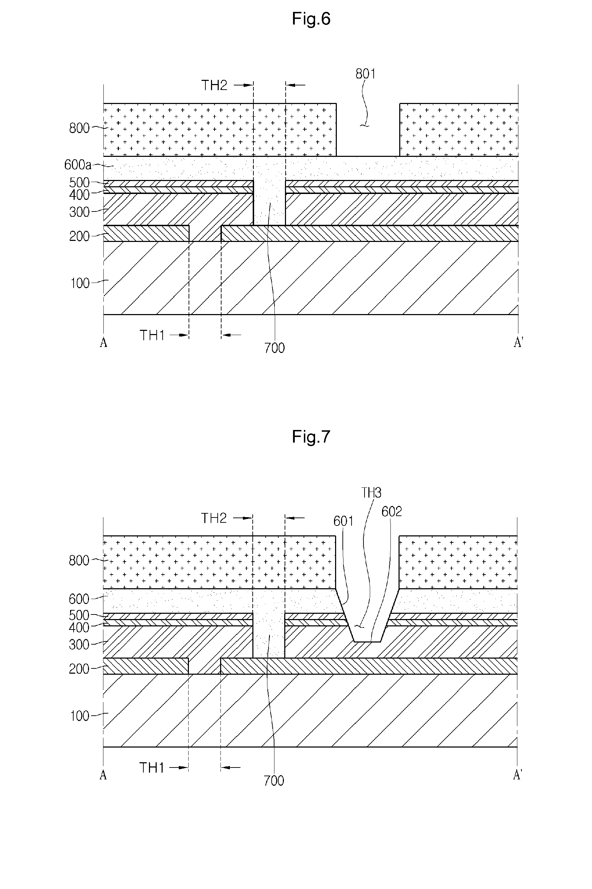

Referring to FIG. 6, a mask pattern 800 is formed on the transparent conductive layer 600a. The mask pattern 800 includes exposure holes 801 to expose the top surface of the transparent conductive layer 600a. The exposure holes 801 are adjacent to the second through holes TH2. The exposure holes 801 extend in a first direction.

For example, the mask pattern 800 may include a silicon oxide or a silicon nitride.

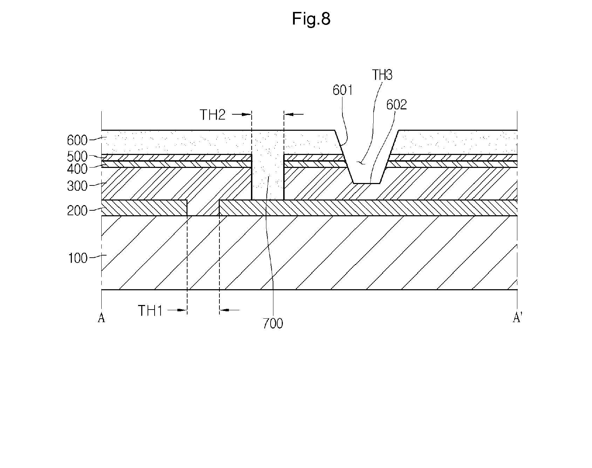

Referring to FIGS. 7 and 8, the transparent conductive layer 600a is etched through a wet etching scheme. Therefore, the third through holes TH3 are formed through the transparent conductive layer 600a, the high resistance buffer layer 500, and the buffer layer 400. The third through holes TH3 are formed through a portion of the light absorbing layer 300.

Various etching solutions may be used in order to form the third through holes TH3. Since the third through holes TH3 are etched through a wet etching scheme, the inner lateral side 601 of the third through holes TH3 may be inclined.

In addition, the third through holes TH3 may be formed by a laser. The laser is irradiated on the upper portion of the light absorbing layer 300. In other words, the laser is irradiated on the upper portion of the light absorbing layer 300 so that the energy of the laser is concentrated on the upper portion of the light absorbing layer 300. Therefore, the laser may form the third through holes TH3 so that the portion of the light absorbing layer 300 is perforated.

The window layer 600 including the third through holes TH3 is formed through the wet etching scheme or the laser patterning scheme. In other words, the transparent conductive layer 600a is divided into a plurality of windows by the third through holes TH3 to form the window layer 600.

In other words, a plurality of windows and a plurality of cells C1, C2, ..., and CN are defined in the window layer 600 by the third through holes TH3. The third through holes TH3 have a width in the range of about 80µm to about 200µm.

Since the third through holes TH3 are formed by the etching process, foreign matters created when the third through holes TH3 are formed can be easily removed. In particular, the foreign matters are cleaned by the etching solution, and the foreign matters remaining in the third through holes TH3 can be easily removed.

In addition, since the third through holes TH3 are formed through an etching process, the third through holes TH3 are formed with smooth inner lateral sides 601. In other words, the smoother inner lateral side 601 of the third through holes TH3 is formed through an etching process rather than a scribing process.

Therefore, the short occurring in the window layer 600 can be prevented. In other words, the performance of a solar cell panel according to the embodiment can be prevented from being degraded due to the short between the windows.

In addition, since the smooth inner lateral side 601 of the third through holes TH3 is formed, the width of the third through holes TH3 may be narrowed. In other words, when comparing with a mechanical scribing process, the etching process can sufficiently mechanically and/ or electrically separate the windows from each other even if the width of the third through holes TH3 is narrowed.

Therefore, the effective area of the solar cell panel according to the embodiment, that is, a power generation area may be actually increased. Therefore, according to the solar cell panel of the embodiment, a short phenomenon can be prevented and improved photoelectric efficiency can be represented.

Any reference in this specification to "one embodiment," "an embodiment," "example embodiment," etc., means that a particular feature, structure, or characteristic described in connection with the embodiment is included in at least one embodiment of the invention. The appearances of such phrases in various places in the specification are not necessarily all referring to the same embodiment. Further, when a particular feature, structure, or characteristic is described in connection with any embodiment, it is submitted that it is within the purview of one skilled in the art to effects such feature, structure, or characteristic in connection with other ones of the embodiments.

Although embodiments have been described with reference to a number of illustrative embodiments thereof, it should be understood that numerous other modifications and embodiments can be devised by those skilled in the art that will fall within the spirit and scope of the principles of this disclosure. More particularly, various variations and modifications are possible in the component parts and/or arrangements of the subject combination arrangement within the scope of the disclosure, the drawings and the appended claims. In addition to variations and modifications in the component parts and/or arrangements, alternative uses will also be apparent to those skilled in the art.

### Industrial Applicability

The solar cell apparatus according to the embodiment and a method of fabricating the same are applicable for the field of solar light generation.

## Claims

1. A solar cell apparatus comprising:
a substrate;
a back electrode layer on the substrate;
a light absorbing layer on the back electrode layer; and
a window layer on the light absorbing layer,
wherein a third through hole is formed through an entire portion of the window layer and a portion of the light absorbing layer.

2. The solar cell apparatus of claim 1, wherein a first through hole is formed through the back electrode layer while being adjacent to the third through hole, and a second through hole is formed through the light absorbing layer while being interposed between the first and third through holes.

3. The solar cell apparatus of claim 1, wherein an inner lateral side of the third through hole is inclined with respect to a top surface of the window layer.

4. The solar cell apparatus of claim 3, wherein the inner lateral side of the third through hole forms an angle in a range of about 3° to about 10° with respect to a direction perpendicular to the top surface of the window layer.

5. The solar cell apparatus of claim 1, further comprising a buffer layer interposed between the light absorbing layer and the window layer, wherein the third through hole is formed through an entire portion of the buffer layer.

6. The solar cell apparatus of claim 1, wherein a bottom surface of the third through hole is interposed between a top surface and a bottom surface of the light absorbing layer.

7. A solar cell apparatus comprising:
a substrate;
a back electrode layer on the substrate;
a light absorbing layer on the back electrode layer;
a window layer having a third through hole on the light absorbing layer; and
a dummy protective part interposed between the third through hole and the back electrode layer.

8. The solar cell apparatus of claim 7, wherein the dummy protective part is integrally formed with the light absorbing layer.

9. The solar cell apparatus of claim 7, wherein the dummy protective part corresponds to the third through hole.

10. The solar cell apparatus of claim 7, wherein a top surface of the dummy protective part is interposed between a top surface and a bottom surface of the light absorbing layer.

11. The solar cell apparatus of claim 7, wherein the dummy protective part covers a top surface of the back electrode layer.

12. The solar cell apparatus of claim 7, wherein a top surface of the dummy protective part is aligned in line with a bottom surface of the third through hole.

13. The solar cell apparatus of claim 7, further comprising a buffer layer interposed between the light absorbing layer and the window layer, wherein the third through hole is formed through an entire portion of the buffer layer and a portion of the light absorbing layer.

14. A method of fabricating a solar cell apparatus, the method comprising:
forming a back electrode layer on a substrate;
forming a light absorbing layer on the back electrode layer;
forming a window layer on the light absorbing layer; and
forming a third through hole through an entire portion of the window layer and a portion of the light absorbing layer.

15. The method of claim 14, wherein the forming of the third through hole comprises:
forming a mask pattern on the window layer; and
etching the window layer and the light absorbing layer by using the mask pattern as an etching mask.

16. The method of claim 14, wherein, in the forming of the third through hole, the window layer and the light absorbing layer are patterned through a wet etching scheme.

17. The method of claim 14, wherein the forming of the third through hole comprises irradiating a laser onto the light absorbing layer.
